(19) **Europäisches Patentamt / European Patent Office / Office européen des brevets**

(11) **EP 4 558 837 B1**

(12) **EUROPEAN PATENT SPECIFICATION**

(45) Date of publication and mention of the grant of the patent:
**15.04.2026 Bulletin 2026/16**

(21) Application number: **23734295.1**

(22) Date of filing: **26.06.2023**

(51) International Patent Classification (IPC):
**G01R 31/08** *(2020.01)*

(52) Cooperative Patent Classification (CPC):
**G01R 31/085; G01R 31/083**

(86) International application number:
**PCT/EP2023/067283**

(87) International publication number:
**WO 2024/017569 (25.01.2024 Gazette 2024/04)**

(54) **A METHOD AND A FAULT LOCATOR SYSTEM FOR DETERMINING A LOCATION OF A FAULT IN A TRANSMISSION LINE**

VERFAHREN UND FEHLERORTUNGSSYSTEM ZUR BESTIMMUNG EINES FEHLERORTES IN EINER ÜBERTRAGUNGSLEITUNG

PROCÉDÉ ET SYSTÈME DE LOCALISATION DE DÉFAUT POUR DÉTERMINER L'EMPLACEMENT D'UN DÉFAUT DANS UNE LIGNE DE TRANSMISSION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **19.07.2022 EP 22185854**

(43) Date of publication of application:
**28.05.2025 Bulletin 2025/22**

(73) Proprietor: Hitachi Energy Ltd
**8050 Zürich (CH)**

(72) Inventors:
- **ABEYWICKRAMA, Nilanga**
  **723 51 Västerås (SE)**
- **BENGTSSON, Tord**
  **723 49 VÄSTERÅS (SE)**
- **GHOSH, Riddhi**
  **72241 Vasteras (SE)**
- **KJELLSSON, Jimmy**
  **72597 Västerås (SE)**

(74) Representative: **AWA Sweden AB**
**Matrosgatan 1**
**Box 5117**
**200 71 Malmö (SE)**

(56) References cited:
EP-A1- 2 546 943          US-A1- 2009 315 537
US-A1- 2015 081 235      US-A1- 2021 409 034
US-B1- 9 698 809

- RADOVANOVIC A ED - BELL KEITH ET AL: "Using the Internet in networking of synchronized phasor measurement units", INTERNATIONAL JOURNAL OF ELECTRICAL POWER & ENERGY SYSTEMS, JORDAN HILL, OXFORD, GB, vol. 23, no. 3, 1 March 2001 (2001-03-01), pages 245 - 250, XP002262960, ISSN: 0142-0615, DOI: 10.1016/S0142-0615(00)00067-3
- NAIDU O D ET AL: "Precise Traveling Wave-Based Transmission Line Fault Location Method Using Single-Ended Data", IEEE TRANSACTIONS ON INDUSTRIAL INFORMATICS, IEEE SERVICE CENTER, NEW YORK, NY, US, vol. 17, no. 8, 29 September 2020 (2020-09-29), pages 5197 - 5207, XP011852825, ISSN: 1551-3203, [retrieved on 20210503], DOI: 10.1109/TII.2020.3027584

## Description

TECHNICAL FIELD

The present disclosure generally relates to the field of fault location in an electrical power transmission system, specifically fault location in a transmission line.

BACKGROUND

A fault in an electrical transmission line of an electrical power transmission system may be caused by, for example but not limited to, a short circuit, a failure of the transmission line, or a blown fuse or circuit breaker. The fault may disable parts, or the whole, of the electrical power transmission system. Therefore, it is of interest to locate the fault as soon as possible so as to be able to provide repairing, replacement and/or maintenance of the faulty transmission line, such that the electrical power transmission system may be returned to a more functional state.

The fault may cause travelling waves to propagate from the location of the fault in opposite directions along the transmission line. The location of the fault may be determined by sampling signals of the transmission line in order to identify arrivals of the travelling waves, wherein the determination of the location of the fault is based on the identification of the arrivals of the travelling waves.

However, velocity of propagation of the travelling waves is high and wave front rise times of travelling waves could be as low as a few microseconds. Therefore, a sampling rate of the signals of the transmission line needs to be sufficiently high to be able to register the arrival of a travelling wave. Travelling wave-based fault locators often use a sampling rate above 1MHz in order to be able to register arrivals of travelling waves. However, a higher sampling rate provides more data, which in turn requires more processing power in order to analyze the data. Equipment that is competent to perform the sampling and processing required to determine a fault location may be complex, costly and/or fragile.

It is therefore of interest to provide an alternative way of determining a location of a fault in a transmission line.

Examples of prior art may be found in US2015/081235 relating to fault location using traveling waves by calculating traveling wave arrival time, EP2546943 relating to a control system, a transformer, a security control device and a bitstream memory unit, US2009/315537 relating to a sampling module and a method of sampling one or more analogue characteristics of a power transmission system, and US9698809 relating to systems and methods for analog to digital converter failure identification.

SUMMARY

An object of the present disclosure is to provide a method and a fault locator system for determining a location of a fault in a transmission line

To achieve this object, the present disclosure provides a method, a fault locator system, and a fault locator device for determining a location of a fault in a transmission line, as defined by the independent claims. Further embodiments are provided in the dependent claims.

According to a first aspect of the present disclosure, a method for determining a location of a fault in a transmission line is provided. The fault causes a first travelling wave and a second travelling wave to propagate from the location in opposite directions along the transmission line. The method comprises determining a first arrival time of the first travelling wave at a first location and a second arrival time of the second traveling wave at a second location, determining the location of the fault based at least on a difference between the first and second arrival times and a wave speed of the first and second travelling waves along the transmission line. The method further comprises sampling signals of the transmission line, at a modulation rate, using Delta-Sigma modulation at the first location of the transmission line and at the second location of the transmission line, filtering the signals sampled at the first location, and providing, at a first output rate, first output samples based on the filtered signals sampled at the first location, filtering the signals sampled at the second location, and providing, at a second output rate, second output samples based on the filtered signals sampled at the second location. The determination of the first arrival time is based on a set of the first output samples, and the determination of the second arrival time is based on a set of the second output samples. The modulation rate is higher than the first and second output rates.

According to a second aspect of the present disclosure, a fault locator system for determining a location of a fault in a transmission line is provided. The fault locator system comprises a processing unit. The processing unit is configured to: determine a first arrival time of the first travelling wave at a first location and a second arrival time of the second traveling wave at a second location, and determine the location of the fault based at least on a difference between the first and second arrival times and a wave speed of the first and second travelling waves along the transmission line. The fault locator system further comprises at least one Delta-Sigma modulator connected to the transmission line at a first location and a second location. The at least one Delta-Sigma modulator is configured to sample signals of the transmission line at a first modulation rate at the first location of the transmission line and configured to sample signals of the transmission line at a second modulation rate at the second location of the transmission line. The fault locator system further comprises at least one filter configured to filter the signals sampled at the first location and the signals sampled at the second location. The at least one filter is configured to: provide, to the processing unit, first output samples, at a first output rate, based on the filtered signals sampled at the first location and second output samples, at a second output rate, based on the filtered signals sampled at the second location. The Delta-Sigma modulator may be communicatively connected to the processing unit and/or the filter. The processing unit is further configured to: determine the first arrival time based on a set of the first output samples and the second arrival time based on a set of the second output samples. The first and second modulation rates are higher than the first and second output rates.

According to a third aspect of a fault locator device for determining a location of a fault in a transmission line is provided. The fault locator device comprises a processing unit. The processing unit is configured to operate in accordance with the method of the first aspect of the present invention. The processing unit may be communicatively connected to a Delta-Sigma modulator, a filter and/or a Delta Sigma Analog-to-Digital Converter, ADC.

Traditional travelling wave-based fault locators often use sample-and-hold-type ADCs with a sampling rate of above 1 MHz. Such ADCs differ significantly from modules used within electrical power transmission systems to provide conventional protection. Further, it is known that in order to acquire a more exact, or detailed, determination of a travelling wave arrival time, the sampling rate should be increased. However, in order to determine a travelling wave arrival time, the recorded samples need to be processed, wherein the processing may comprise the recorded samples being filtered, i.e. smoothed, and being, for example, differentiated. An effect of such processing is that details, i.e. information, of the initial recorded samples is lost in the process, which may result in an error of the determination. Further, traditional travelling wave-based fault locators may utilize polynomial fitting in order to determine a travelling wave arrival time, which is a more costly, more inexact and/or more time-consuming, process with regards to hardware and/or software resources.

The method, the fault locator system and the fault locator device of the present disclosure is based on utilizing the inherent averaging and smoothing effect of the combination of Delta-Sigma modulation and subsequent filtering. The combination may result in a lower sampling output rate, such as lower than 1 MHz or 500 kHz, in comparison to the sampling output rate of traditional travelling wave-based fault locators, which is often at least 1 MHz. However, due to a modulation rate which is higher than the sampling output rates, the combination may be able to register faster transmission line signal changes than traditional travelling wave-based fault locators. In the present method, the modulation rate may for example be at least 20 MHz. A benefit of the present disclosure is thereby that fault location may be provided while utilizing a lower sampling output rate and/or while requiring a reduced amount of hardware and/or software resources. This in turn allows for the use of modules already present in electrical power transmission systems for protection purposes to also determine fault locations.

The subsequent filtering of the present disclosure may cause a delay of the determination of a travelling wave arrival time. However, the present disclosure is further based on the realization that delays of the determinations of travelling wave arrival times are identical or nearly identical, such that two such determinations are delayed by the same time or at least nearly the same time. Hence, it has been realized that, in order to determine a location of a fault, the relevant parameter is the time difference between two determinations of travelling wave arrival time rather than the determinations of the travelling wave arrival times as such. Thus, the present disclosure may provide an accurate fault location determination, which depends on the accuracy of the time difference determination, even though the determined travelling wave arrival times are delayed and thereby less accurate. The present disclosure may thereby provide a method, a fault locator system and a fault locator device for determining a fault location that require less hardware and/or software resources.

It is to be understood that the present disclosure is not limited to determination of a fault in a transmission line, and may further relate to determination of a fault in a transmission cable, such as an underground transmission cable. The transmission line may be connected between generating stations and/or distribution stations of an electrical transmission system, such as a national or regional power grid. The transmission line may be designated for one phase of a plurality of phases, such as, for example, being a conductor for one phase in a three-phase transmission line arrangement. According to another alternative, the transmission line may be a single-phase transmission line.

By the term "wave speed", it is meant the speed at which a wave propagates within the transmission line. Wave speed may also be referred to as, for example, wave velocity or propagation speed, which may be a function of dielectric and magnetic material properties.

The signals of the transmission line may comprise information indicative of the current and/or the voltage of the transmission line. Thus, sampling signals of the transmission line may comprise sampling currents and/or voltage of the transmission line.

The modulation rate(s) may be understood as, for example, a rate at which a Delta-Sigma modulator is able to sample signals, and/or as a rate at which signals are sampled using Delta-Sigma modulation. Further, the output rate(s) may be understood as, for example, a rate at which samples are output or provided by a filter, a Delta-Sigma modulator or a Delta-Sigma ADC. In other words, the modulation rate(s) may, alternatively, be understood as input sampling rate(s), and the output rate(s) may, alternatively, be understood as output sampling rate(s).

Delta-Sigma modulation is a method for encoding analog signals to digital signals. Delta-Sigma modulation may comprise encoding the change of a signal, i.e. the delta of the signal, instead of the absolute value, as is common for a conventional analog-to-digital converter, ADC, so as to produce a stream of pulses rather than a stream of numbers.

The sets of first and second output samples may be a plurality of consecutive first output samples and second output samples, respectively.

The signals sampled at the first location may be filtered using low-pass filtering, averaging filtering or sinc-filtering, and the signals sampled at the second location may be filtered using a low-pass filter, an averaging filter or a sinc-filter. The at least one filter may include at least one of a low-pass filter, an averaging filter and a sinc-filter, which may be configured to filter the signals sampled at the first location and/or the signals sampled at the second location. The low-pass filter, an averaging filter or a sinc-filter may provide higher-resolution but lower sample-frequency digital output, which may simplify circuit design and/or improve efficiency. An averaging filter may be understood as a type of low-pass filter, which outputs the average of a series of inputs. An averaging filter may alternatively be termed a moving average-filter. A sinc-filter may also be understood as a type of low-pass filter. Further, a sinc-filter may be understood as an idealized filter that removes all frequency components above a given cutoff frequency, without affecting lower frequencies, and has linear phase response. A sinc-filter may alternatively be termed a brick-wall filter. Further, a sinc-filter may be implemented as a group-averaging filter.

The first and second output samples may indicate a change of current or a change of voltage. The method may further comprise determining a first peak change of the set of the first output samples and a second peak change of the set of the second output samples. The processing unit of the fault locator system may be configured to determine a first peak change of the set of the first output samples and a second peak change the set of the second output samples. The determination of the first arrival time may be based on an arrival time of the first peak change, and the determination of the second arrival time may be based on an arrival time of the second peak change. Due to the lower output rate of the present disclosure, the determination of the first and second peak changes may be provided using less hardware and/or software resources compared to traditional travelling wave-based fault location, thereby providing an improved efficiency.

The first location and the second location may be the same, or at a same position along the transmission line. The at least one Delta-Sigma modulator may comprise a single Delta-Sigma modulator located at the first and second locations. The second travelling wave may be a reflected travelling wave. Thus, the single Delta-Sigma modulator may be configured to sample the signals at the first and second location, as they may be the same, wherein each set of signals may be sampled at the modulation rate, respectively. The first location and the second location being the same may be understood as using a single-end method for determining a fault location. A benefit of the first location and the second location being the same may be that it may allow for a less complex system, or implementation of the present disclosure, in comparison to a system, or implementation, which utilizes sampling at two different locations.

A determination of the fault location, using the single-end method, may be determined by calculating a distance from the first location to the fault location, or from an end of the transmission line opposite to the first location to the fault location. The distance from the end of the transmission line to the fault location may be calculated by determining a time difference between the arrivals of the first and second travelling waves, and multiplying the determined time difference with the wave speed, and dividing the result by two. The distance from the first location to the fault location is equal to a distance between the first location and the end of the transmission line opposite to the first location subtracted by the determined distance from the end of the transmission line to the fault location.

The first location and the second location may be different and/or located at opposite positions along the transmission line relative to the fault location. The at least one Delta-Sigma modulator may comprise a first Delta-Sigma modulator located at the first location and a second Delta-Sigma modulator located at the second location. Thus, the sampling may be performed at different locations, which may provide flexibility when determining the fault location. The first location and the second location being different may be understood as using a double-end method for determining a fault location. However, in order to accurately determine the fault location, the samplings at the different locations may need to be time-synchronized, which may require additional hardware and/or software resources.

The determination of the location of the fault may be further based on a distance between the first and second locations and/or a geographical (or georeferenced) position of at least one of the first and second locations. The distance between the first and second locations may be a length of the transmission line between the first and second locations.

The determination of the fault location, using the double-end method, may include determining a distance from the first location to the fault location. The distance from the first location to the fault location may be calculated by determining a time difference between the arrivals of the first and second travelling waves, multiplying the determined time difference with the wave speed, subtracting this later value (i.e. the time difference multiplied by the wave speed) from the distance between the first and second locations (which may correspond to the length of the transmission line if the two locations are at opposite ends of the transmission line) and dividing the result by two.

The first output rate and the second output rate may be the same. In an exemplary embodiment, in which the first and second locations are the same, i.e. using a single-end method, the first output rate and the second output rate being the same may be due to a single filter, or single Delta-Sigma ADC, outputting the first and second output samples. In the case of the first and second locations being different, i.e. a double-end method, the first output rate and the second output rate may also be the same, which may be due to using the same kind of filtering and/or Delta-Sigma ADC. Correspondingly, the first modulation rate and the second modulation rate may be the same.

The modulation rate may be at least ten (10) times higher than the first and second output rates. In particular, the first and second modulation rates may be at least ten (10) times higher than the first and second output rates, respectively. Further, the modulation rate(s) may be at least 20, 30, 40 or 50 times higher than the output rate(s). Higher modulation rate(s) may allow for registering faster transmission line changes, i.e. being able to more accurately register arrival times of travelling waves, while the lower output rate may reduce the hardware and/or software resources required to determine the arrival times of travelling waves. Thus, a more efficient determination of a fault location may be provided. This effect may be increased by an increased difference between the modulation rate(s) and the output rate(s).

The modulation rate, the first modulation rate and/or the second modulation rate may be above 10 MHz. For example, the modulation rate(s) may be above 15 MHz, 20 MHz, 25 MHz, or 30 MHz.

The fault locator system may comprise at least one Delta-Sigma ADC comprising the at least one Delta-Sigma modulator and the at least one filter. The first location and the second location may be the same, or at a same position along the transmission line, and the at least one Delta-Sigma modulator may comprise a single Delta-Sigma ADC located at said first and second locations, and wherein the second travelling wave is a reflected travelling wave. Alternatively, the first location and the second location may be different and/or located at opposite positions along the transmission line relative to the fault location, and the at least one Delta-Sigma ADC may comprise a first Delta-Sigma ADC located at said first location and a second Delta-Sigma ADC located at said second location. However, the fault locator system according to the present disclosure is not limited to a Delta-Sigma ADC comprising the at least one Delta-Sigma modulator and the at least filter. For example, the fault locator system may comprise at least one Delta-Sigma modulator and at least one filter, which are communicatively connected so as to form a Delta-Sigma ADC.

Other objectives, features and advantages of the enclosed embodiments will be apparent from the following detailed disclosure, from the attached dependent claims as well as from the drawings.

It is noted that embodiments of the invention relate to all possible combinations of features recited in the claims. Further, it will be appreciated that the various embodiments described for the method as defined in accordance with the first aspect, the embodiments described for the fault locator system according to the second aspect and the fault locator device according to the third aspect are all combinable with each other.

BRIEF DESCRIPTION OF THE DRAWINGS

This and other aspects of the present disclosure will now be described in more detail, with reference to the appended drawings showing embodiment(s) of the disclosure.

Figs. 1a, 1b and 2 schematically show fault locator systems according to exemplifying embodiments of the present disclosure.
Fig. 3 shows a flowchart of a method according to an exemplifying embodiment of the present disclosure.

DETAILED DESCRIPTION

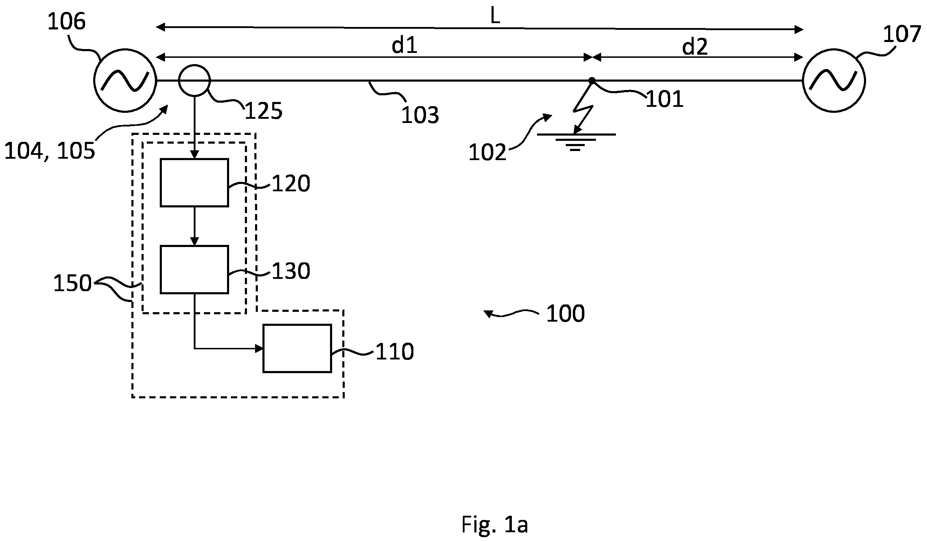

Fig. 1a schematically shows a fault locator system 100 for determining a location 101 of a fault 102 in a transmission line 103 according to an exemplifying embodiment of the present disclosure.

The transmission line 103 is connected between two stations 106, 107, such that opposite ends of the transmission line 103 is connected to a respective station 106, 107. The stations 106, 107 may be, for example, generator stations or distribution stations. The transmission line 103 has a length L, which may be more than 10 km or 100 km. A fault 102 has occurred in the transmission line 103 at a location 101. The fault 102 causes a first travelling wave and a second travelling wave to propagate in opposite directions along the transmission line 103.

The fault locator system 100 comprises a Delta-Sigma modulator 120 which is connected to the transmission line 103 at a first location 104, wherein the first location 104 is the same as a second location 105. The first location 104 is at a first end of the transmission line 103 connected to a first station 106 of the two stations 106, 107. The fault locator system 100 shown in Fig. 1a may thereby be understood as a single-end system, and/or a system configured for using a single-end method, as it is configured to determine the fault location 101 using a single Delta-Sigma modulator 120 arranged at one end of the transmission line 103, i.e. the first location 104 which is the same as the second location 105. The second travelling wave is therefore a reflected wave which has first travelled from the fault location 101, to a second end of the transmission line 103 and then travelled back to the first location 104, 105.

The fault location 101 as shown in Fig. 1a is located in a half of the transmission line 103 which is furthest away from the fault locator system 100. In order to correctly determine the fault location 101, it may also be determined in which half of the transmission line 103, i.e. closest half or furthest half of the transmission line 103, that the fault 102 is located. Information about which zone, portion, or half, of the transmission line in which the fault is located may be obtained in different ways, such as, for example, described in patent application EP 3 961836 A1 and more specifically, paragraphs [0006] to [0020], or the article entitled "Precise Traveling Wave Based Transmission Line Fault Location Method Using Single-Ended Data", by O. D. Naidu and Ashok Kumar Pradhan and published in IEEE Transaction on Industrial Informatics, Volume 17, Issue: 8, Aug 2021, and more specifically, the method disclosed in section II.D. Proposal Faulted Half Segment Identification of said article.

The fault location 101 is at a first distance d1 from the first end of the transmission line 103, and at a second distance d2 from the second end of the transmission line 103. Thus, the length L of the transmission line 103 is equal to the sum of the two distances d1, d2.

The second distance d2 is determined by subtracting the arrival time of the first travelling wave ($t_1$) from the arrival time of the second travelling wave (t2), multiplying the result with the wave speed Y of the first and second travelling waves, and dividing the result with two, in accordance with the following equation:

$$d2 = (t_2 - t_1)\frac{\gamma}{2}$$

. Consequently, the first distance d1 is determined by subtracting the second distance d2 from a length (l) of the transmission, in accordance with the following equation:

$$d1 = l - d2 = l - (t_2 - t_1)\frac{\gamma}{2}$$

.

The Delta-Sigma modulator 120 may be connected to the transmission line 103 at the first location 104 via a sensor unit 125. It is to be understood that the transmission line 103, as shown in Fig. 1a, is not to scale, and therefore that a distance between the first end of the transmission line 103 and the point at which the Delta-Sigma modulator 120 is connected to the transmission line 103 is not proportional to the length L of the transmission line 103. For example, the transmission line 103 may be at least 10 km, or 100km, while the distance between the first end of the transmission line 103 and the point at which the Delta-Sigma modulator 120 is connected may be less than a few meters. A difference of a few meters is barely measurable when dealing with transmission lines 103 having lengths of over 10 km, and with travelling waves travelling at such high speeds. Further, within the field of fault location, an error of less than 100 meters is deemed sufficient. Therefore, the first location 104 may be understood as a portion of the transmission line 103 comprising at least the first end of the transmission line 103 and the point at which the Delta-Sigma modulator 120 is connected.

The fault locator system 100 comprises a processing unit 110. The processing unit 110 is configured to determine a first arrival time of the first travelling wave at the first location 104 and a second arrival time of the second traveling wave (i.e. the wave reflected at the end of the transmission line opposite to the location 104) at the first location 104. The processing unit 110 is further configured to determine the location 101 of the fault 102 based at least on a difference between the first and second arrival times and a wave speed of the first and second travelling waves along the transmission line 103. Determination of the location 101 of the fault 102, by the processing unit 110, may be further based on a geographical (or georeferenced) position of the first location 104.

The Delta-Sigma modulator 120 is configured to sample signals of the transmission line 103 at a modulation rate at the first location 104. The modulation rate may be above 10 MHz, or above 20 MHz.

The fault locator system 100 further comprises a filter 130, which may be communicatively connected to the Delta-Sigma modulator 120. The filter 130 is configured to filter the signals sampled by the Delta-Sigma modulator 120. The filter 130 may comprise a low-pass filter, an averaging filter and/or a sinc-filter. Further, the filter 130 is configured to provide output samples, at an output rate, based on the filtered signals sampled at the first location 104 to the processing unit 110. The modulation rate of the Delta-Sigma modulator 120 is higher, such as at least 10 times higher, than the output rate of the filter 130.

The processing unit 110 is further configured to determine the first arrival time based on a set of the first output samples and the second arrival time based on a set of the second output samples.

The fault locator system 100 may comprise a Delta-Sigma Analog-to-Digital Converter, ADC, 150. The Delta-Sigma ADC 150 may comprise the Delta-Sigma modulator 120 and the filter 130. However, the Delta-Sigma modulator 120 and the filter 130 may be arranged apart from each other. Further, the Delta-Sigma ADC 150 may alternatively also comprise the processing unit 110 of the fault locator system 100.

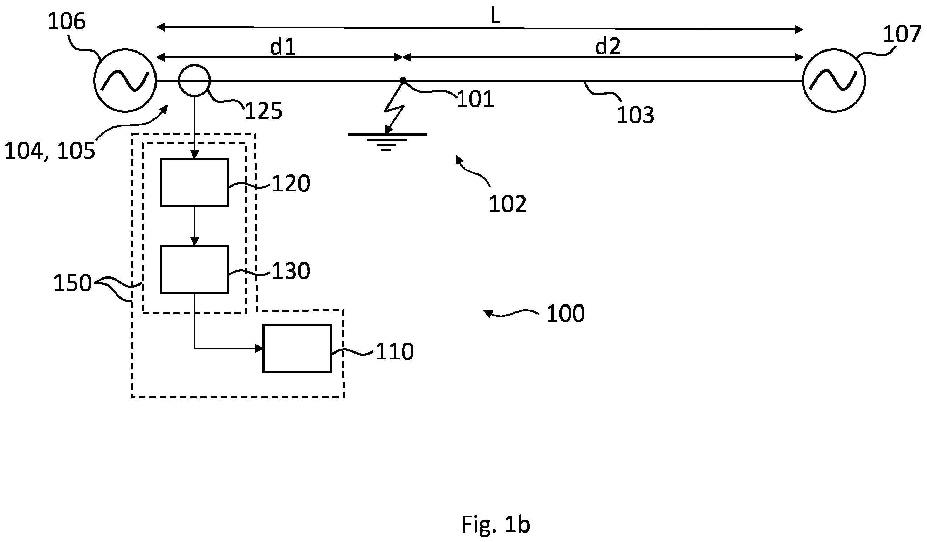

Fig. 1b schematically shows a fault locator system 100 for determining a location 101 of a fault 102 in a transmission line 103 according to an exemplifying embodiment of the present disclosure.

A difference between the fault locator systems 100 shown in Figs. 1a and 1b, is that the fault location 101 shown in Fig. 1b is in the half of the transmission line 103 which is closest to the fault locator system 100, rather than in the half furthest from the fault locator system 100, as shown in Fig. 1a.

In the exemplary embodiment shown in Fig. 1b, the second travelling wave corresponds to the first travelling wave being first reflected at a first end (or first location) 104, 105 of the transmission line 103 and travelling back to the fault location 101 at which it is again reflected to travel back to the first location 104, 105. Thus, the second travelling wave is a reflected wave, which has reflected twice, firstly at a first end of the transmission line 103 and secondly at the fault location 102.

The first distance d1 is determined by subtracting the arrival time of the first travelling wave ($t_1$) from the arrival time of the second travelling wave (t2), multiplying the result with the wave speed Y of the first and second travelling waves, and dividing the result with two, in accordance with the following equation:

$$d1 = (t_2 - t_1)\frac{\gamma}{2}\ .$$

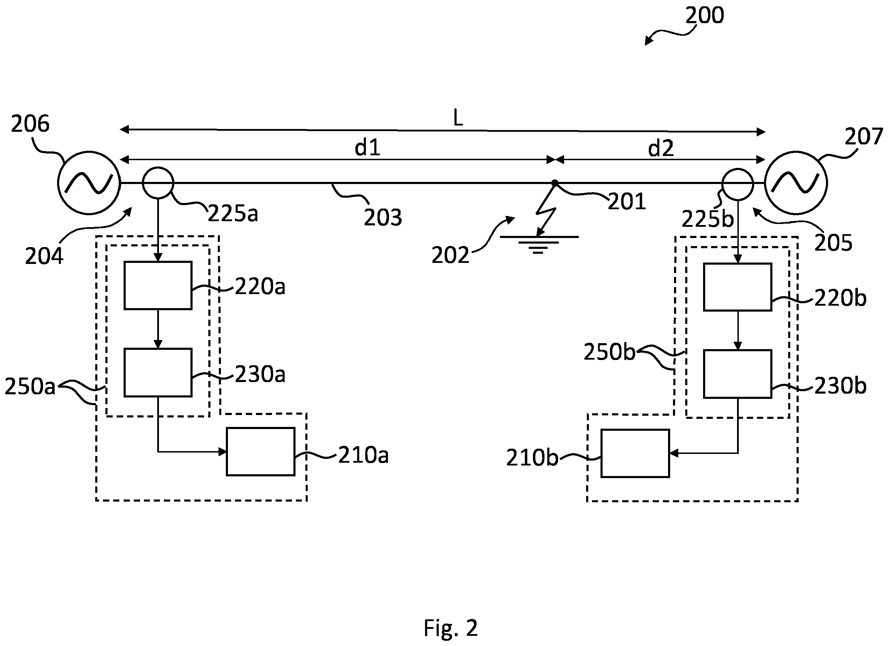

Fig. 2 schematically shows a fault locator system 200 for determining a location 201 of a fault 202 in a transmission line 203 according to an exemplifying embodiment of the present disclosure. It should be noted that Fig. 2 comprises features, elements and/or functions as shown in Figs. 1a and 1b and described in the associated texts. The features are identified by reference numbers made up of the number of the figure to which it relates followed by the number of the feature, which are equivalents for all exemplifying embodiments, e.g. the common feature "10" is indicated by "110" in Figs. 1a and 1b while the corresponding feature is indicated by "210" in Fig. 2. Hence, it is also referred to Figs. 1a and 1b and the descriptions relating thereto for an increased understanding.

A difference between the fault locator system 200 shown in Fig. 2 and the fault locator system shown in Figs. 1a and 1b is that the fault locator system 200 comprises two sets of components, wherein each set comprises a Delta-Sigma modulator 220a, 220b, a filter 230a, 230b, and a processing unit 210a, 210b. Each of the two sets is equivalent to the fault locator systems 100 shown in Figs. 1a and 1b. However, a first Delta-Sigma modulator 220a of a first set of the two sets is connected to the transmission line 203 at a first location 204 of the transmission line 203, and a second Delta-Sigma modulator 220b of a second set of the two sets is connected to the transmission line 203 at a second location 205 of the transmission line 203. The first location 204 and the second location 205 may be at opposite ends of the transmission line 205. The first and second Delta-Sigma modulators 220a, 220b are configured to sample signals at the first location 204 at a first modulation rate, and at the second location 205 at a second modulation rate, respectively. The first and second modulation rates may be the same or different.

A first filter 230a of the first set is communicatively connected to the first Delta-Sigma modulator 220a, and a second filter of the second set is communicatively connected to the second Delta-Sigma modulator 220b. The filters 230a, 230b are configured to filter the signals sampled at the first location 204 and the second location 205, respectively.

The first filter 230a and the second filter 230b are configured to provide, to a respective processing unit 210a, 210b, at a first output rate, first output samples based on the filtered signals sampled at the first location 204, and, at a second output rate, second output samples based on the filtered signals sampled at the second location 205, respectively.

The present disclosure is not limited to comprising two processing units 210a, 210b, as shown in Fig. 2. For example, the fault locator system 200 may comprise a single processing unit configured to receive the filtered signals sampled at the first location 204 and the filtered signals sampled at the second location 205. Further, the present disclosure is not limited to filters 230a, 230b as shown in Fig. 2. For example, the fault locator system 200 may comprise a single filter which is communicatively connected to both Delta-Sigma modulators 220a, 220b and configured to filter the signals sampled at the first location 204 and the second location 205, and may be configured to provide the filtered signals to a single processing unit.

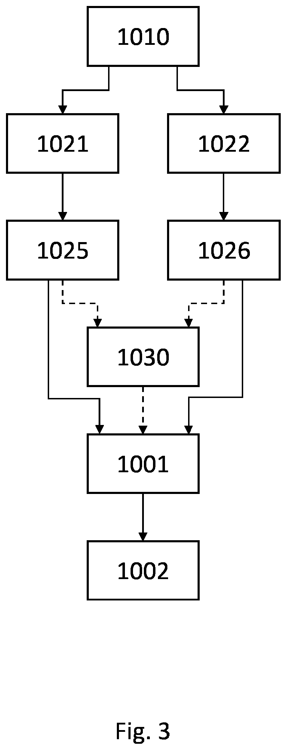

Fig. 3 shows a flowchart of a method 1000 for determining a location of a fault in a transmission line according to an exemplifying embodiment of the present disclosure. The fault causes a first travelling wave and a second travelling wave to propagate from the location in opposite directions along the transmission line. It should be noted that Fig. 3 comprises features, elements and/or functions as shown in Figs. 1a, 1b and 2 and described in the associated texts. Hence, it is also referred to Figs. 1a, 1b and 2 and the descriptions relating thereto for an increased understanding.

The method 1000 comprises sampling 1010 signals of the transmission line, at a modulation rate, using Delta-Sigma modulation at a first location of the transmission line and at a second location of the transmission line. The method 1000 further comprises filtering 1021 the signals sampled at the first location, and providing 1025, at a first output rate, first output samples based on the filtered signals sampled at the first location, and filtering 1022 the signals sampled at the second location, and providing 1026, at a second output rate, second output samples based on the filtered signals sampled at the second location.

In the flowchart shown in Fig. 3, the filtering 1021 of the signals sampled at the first location and the filtering 1022 of the signals at the second location are shown to be done in parallel. However, the filtering 1021, 1022 of the signals sampled at the first and second locations may, alternatively, performed in series and/or consecutively. For example, the first location and the second location may be the same, and thereby signals of the first travelling wave and the second travelling wave may be sampled 1010 at a same location, wherein the first travelling wave may reach the first location before the second travelling wave. In such an example, the filtering 1021 of the signals of the first travelling wave may begin before, or simultaneously with, the sampling 1010 of the signals of the second travelling wave or the filtering 1022 of the signals of the second travelling wave. Correspondingly, the providing 1025, 1026 may also be performed in series and/or consecutively.

Further, the method 1000 comprises determining 1001 a first arrival time of the first travelling wave at the first location based on a set of the first output samples, and determining 1001 a second arrival time of the second travelling wave at a second location based on a set of the second output samples.

Furthermore, the method 1000 comprises determining 1002 the location of the fault based at least on a difference between the first and second arrival times and a wave speed of the first and second travelling waves along the transmission line.

The first and second output samples may indicate a change of current and/or a change of voltage, and the method 1000 may further comprise determining 1030 a first peak change of the set of the first output samples and a second peak change of the set of the second output samples. The determination 1001 of the first and second arrival times may further be based on arrival times of the first and second peak changes.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method (1000) for determining a location of a fault in a transmission line, wherein the fault causes a first travelling wave and a second travelling wave to propagate from said location in opposite directions along the transmission line, the method comprising:

   determining (1001) a first arrival time of the first travelling wave at a first location and a second arrival time of the second travelling wave at a second location;
   determining (1002) the location of the fault based at least on a difference between the first and second arrival times and a wave speed of the first and second travelling waves along the transmission line;
   wherein the method further comprises:

   sampling (1010) signals of the transmission line, at a modulation rate, using Delta-Sigma modulation at the first location of the transmission line and at the second location of the transmission line;
   filtering (1021) the signals sampled at the first location, and providing (1025), at a first output rate, first output samples based on the filtered signals sampled at the first location;
   filtering (1022) the signals sampled at the second location, and providing (1026), at a second output rate, second output samples based on the filtered signals sampled at the second location;
   wherein the determination of the first arrival time is based on a set of the first output samples, and the determination of the second arrival time is based on a set of the second output samples; and
   wherein the modulation rate is higher than the first and second output rates.

2. The method according to claim 1, wherein the signals sampled at the first location are filtered using an averaging filter or a sinc-filter, and wherein the signals sampled at the second location are filtered using an averaging filter or a sinc-filter.

3. The method according to claim 1 or 2, wherein the first and second output samples indicate a change of current or a change of voltage; and

   wherein the method further comprises determining (1030) a first peak change of the set of the first output samples and a second peak change of the set of the second output samples;
   wherein the determination (1001) of the first arrival time is based on an arrival time of the first peak change, and the determination of the second arrival time is based on an arrival time of the second peak change.

4. The method according to any of claims 1 to 3, wherein the first location and the second location are the same, or at a same position along the transmission line, and wherein the second travelling wave is a reflected travelling wave.

5. The method according to any of claims 1 to 3, wherein the first location and the second location are different and/or located at opposite positions along the transmission line relative to the fault location.

6. The method according to claim 5, wherein the determination of a location of the fault is further based on a distance between the first and second locations and/or a geographical position of at least one of the first and second locations.

7. The method according to any preceding claim, wherein the modulation rate is at least 10 times higher than the first and second output rates, and/or wherein the modulation rate is above 10 MHz.

8. A fault locator system (100) for determining a location (101) of a fault (102) in a transmission line (103), wherein the fault causes a first travelling wave and a second travelling wave to propagate in opposite directions along the transmission line, the fault locator system comprising:
a processing unit (110) configured to:

determine a first arrival time of the first travelling wave at a first location (104) and a second arrival time of the second traveling wave at a second location (105, 205);
determine the location of the fault based at least on a difference between the first and second arrival times and a wave speed of the first and second travelling waves along the transmission line;
wherein the fault locator system further comprises:

at least one Delta-Sigma modulator (120) connected to the transmission line at a first location and a second location, and configured to sample signals of the transmission line at a first modulation rate at the first location of the transmission line and configured to sample signals of the transmission line at a second modulation rate at the second location of the transmission line; and
at least one filter (130) configured to filter the signals sampled at the first location and the signals sampled at the second location;

wherein said at least one filter is configured to:
provide, to the processing unit, first output samples, at a first output rate, based on the filtered signals sampled at the first location and second output samples, at a second output rate, based on the filtered signals sampled at the second location; and
wherein the processing unit is further configured to:

determine the first arrival time based on a set of the first output samples and the second arrival time based on a set of the second output samples;
wherein the first and second modulation rates are higher than the first and second output rates.

9. The fault locator system according to claim 8, wherein the at least one filter (130) includes at least one of a low-pass filter, an averaging filter and a sinc-filter.

10. The fault locator system according to claim 8 or 9, wherein determining the location of the fault is further based on a distance between the first and second locations and/or a geographical position of at least one of the first and second locations.

11. The fault locator system according to any of claims 8 to 10, wherein the first and second modulation rates are at least 10 times higher than the first and second output rates, respectively, and/or wherein the first and second modulation rates are above 10 MHz.

12. The fault locator system according to any of claims 8 to 11, wherein the first and second output samples indicate a change of current or a change of voltage; and

wherein the processing unit is further configured to determine a first peak change of the set of the first output samples and a second peak change the set of the second output samples;
wherein the determination of the first arrival time is based on an arrival time of the first peak change, and the determination of the second arrival time is based on an arrival time of the second peak change.

13. The fault locator system according to any of claims 8 to 12,

wherein the first location and the second location are the same, or at a same position along the transmission line, wherein said at least one Delta-Sigma modulator comprises a single Delta-Sigma modulator located at said first and second locations, and wherein the second travelling wave is a reflected travelling wave;
or
wherein the first location and the second location are different and/or located at opposite positions along the transmission line relative to the fault location, and wherein said at least one Delta-Sigma modulator comprises a first Delta-Sigma modulator located at said first location and a second Delta-Sigma modulator located at said second location.

14. The fault locator system according to any of claims 8 to 13, comprising at least one Delta-Sigma ADC (150) comprising the at least one Delta-Sigma modulator and the at least one filter.

**Patentansprüche**

1. Verfahren (1000) zum Bestimmen eines Ortes eines Fehlers in einer Übertragungsleitung, wobei der Fehler das Fortpflanzen einer ersten Wanderwelle und einer zweiten Wanderwelle von dem Ort in entgegengesetzte Richtungen entlang der Übertragungsleitung bewirkt, wobei das Verfahren Folgendes umfasst:

   Bestimmen (1001) einer ersten Ankunftszeit der ersten Wanderwelle an einem ersten Ort und einer zweiten Ankunftszeit der zweiten Wanderwelle an einem zweiten Ort;
   Bestimmen (1002) des Ortes des Fehlers basierend mindestens auf einer Differenz zwischen der ersten und der zweiten Ankunftszeit und einer Wellengeschwindigkeit der ersten und der zweiten Wanderwelle entlang der Übertragungsleitung;
   wobei das Verfahren ferner Folgendes umfasst:

   Abtasten (1010) von Signalen der Übertragungsleitung mit einer Modulationsrate unter Verwendung einer Delta-Sigma-Modulation an dem ersten Ort der Übertragungsleitung und an dem zweiten Ort der Übertragungsleitung;
   Filtern (1021) der an dem ersten Ort abgetasteten Signale und Bereitstellen (1025) erster Ausgabeabtastungen mit einer ersten Ausgaberate, basierend auf den gefilterten an dem ersten Ort abgetasteten Signalen;
   Filtern (1022) der an dem zweiten Ort abgetasteten Signale und Bereitstellen (1026) zweiter Ausgabeabtastungen mit einer zweiten Ausgaberate, basierend auf den gefilterten an dem zweiten Ort abgetasteten Signalen;
   wobei die Bestimmung der ersten Ankunftszeit auf einem Satz der ersten Ausgabeabtastungen basiert und die Bestimmung der zweiten Ankunftszeit auf einem Satz der zweiten Ausgabeabtastungen basiert; und
   wobei die Modulationsrate höher ist als die erste und die zweite Ausgaberate.

2. Verfahren nach Anspruch 1, wobei die an dem ersten Ort abgetasteten Signale unter Verwendung eines Mittelwertfilters oder eines Sinusfilters abgetastet werden und wobei die an dem zweiten Ort abgetasteten Signale unter Verwendung eines Mittelwertfilters oder eines Sinusfilters abgetastet werden.

3. Verfahren nach Anspruch 1 oder 2, wobei die ersten und die zweiten Ausgabeabtastungen eine Veränderung der Stromstärke oder eine Veränderung der Spannung angeben; und

   wobei das Verfahren ferner das Bestimmen (1030) einer ersten Spitzenveränderung des Satzes der ersten Ausgabeabtastungen und einer zweiten Spitzenveränderung des Satzes der zweiten Ausgabeabtastungen umfasst;
   wobei die Bestimmung (1001) der ersten Ankunftszeit auf einer Ankunftszeit der ersten Spitzenveränderung basiert und die Bestimmung der zweiten Ankunftszeit auf einer Ankunftszeit der zweiten Spitzenveränderung basiert.

4. Verfahren nach einem der Ansprüche 1 bis 3, wobei der erste Ort und der zweite Ort gleich sind oder sich an einer gleichen Position entlang der Übertragungsleitung befinden und wobei die zweite Wanderwelle eine reflektierte Wanderwelle ist.

5. Verfahren nach einem der Ansprüche 1 bis 3, wobei der erste Ort und der zweiten Ort verschieden sind und/oder sich an entgegengesetzten Positionen entlang der Übertragungsleitung relativ zu dem Ort eines Fehlers befinden.

6. Verfahren nach Anspruch 5, wobei die Bestimmung eines Ortes des Fehlers ferner auf einem Abstand zwischen dem ersten und dem zweiten Ort und/oder auf einer geografischen Position von mindestens einem des ersten und des zweiten Ortes basiert.

7. Verfahren nach einem der vorhergehenden Ansprüche, wobei die Modulationsrate mindestens 10-mal höher ist als die erste und die zweite Ausgaberate und/oder wobei die Modulationsrate über 10 MHz beträgt.

8. Fehlerortungssystem (100) zum Bestimmen eines Ortes (101) eines Fehlers (102) in einer Übertragungsleitung (103), wobei der Fehler das Fortpflanzen einer ersten Wanderwelle und einer zweiten Wanderwelle in entgegengesetzte Richtungen entlang der Übertragungsleitung bewirkt, wobei das Fehlerortungssystem Folgendes umfasst:
   eine Verarbeitungseinheit (110), die zu Folgendem ausgelegt ist:

   Bestimmen einer ersten Ankunftszeit der ersten Wanderwelle an einem ersten Ort (104) und einer zweiten Ankunftszeit der zweiten Wanderwelle an einem zweiten Ort (105, 205);
   Bestimmen des Ortes des Fehlers basierend mindestens auf einer Differenz zwischen der ersten und der zweiten Ankunftszeit und einer Wellengeschwindigkeit der ersten und der zweiten Wanderwelle entlang der Übertragungsleitung;
   wobei das Fehlerortungssystem ferner Folgendes umfasst:

mindestens einen Delta-Sigma-Modulator (120), der an einem ersten Ort und einem zweiten Ort mit der Übertragungsleitung verbunden und dazu ausgelegt ist, Signale der Übertragungsleitung mit einer ersten Modulationsrate an dem ersten Ort der Übertragungsleitung abzutasten, und der dazu ausgelegt ist, Signale der Übertragungsleitung mit einer zweiten Modulationsrate an dem zweiten Ort der Übertragungsleitung abzutasten; und
mindestens einen Filter (130), der dazu ausgelegt ist, die an dem ersten Ort abgetasteten Signale und die an dem zweiten Ort abgetasteten Signale zu filtern;
wobei der mindestens eine Filter zu Folgendem ausgelegt ist: Bereitstellen erster Ausgabeabtastungen mit einer ersten Ausgaberate basierend auf den gefilterten an dem ersten Ort abgetasteten Signalen und zweiter Ausgabeabtastungen mit einer zweiten Ausgaberate basierend auf den gefilterten an dem zweiten Ort abgetasteten Signalen für die Verarbeitungseinheit; und
wobei die Verarbeitungseinheit ferner zu Folgendem ausgelegt ist:

Bestimmen der ersten Ankunftszeit basierend auf einem Satz der ersten Ausgabeabtastungen und der zweiten Ankunftszeit basierend auf einem Satz der zweiten Ausgabeabtastungen;
wobei die erste und die zweite Modulationsrate höher sind als die erste und die zweite Ausgaberate.

9. Fehlerortungssystem nach Anspruch 8, wobei der mindestens eine Filter (130) mindestens einen von einem Tiefpassfilter, einem Mittelwertfilter und einem Sinusfilter beinhaltet.

10. Fehlerortungssystem nach Anspruch 8 oder 9, wobei das Bestimmen des Ortes des Fehlers ferner auf einem Abstand zwischen dem ersten und dem zweiten Ort und/oder auf einer geografischen Position von mindestens einem des ersten und des zweiten Ortes basiert.

11. Fehlerortungssystem nach einem der Ansprüche 8 bis 10, wobei die erste und die zweite Modulationsrate mindestens 10-mal höher sind als die erste beziehungsweise die zweite Ausgaberate und/oder wobei die erste und die zweite Modulationsrate über 10 MHz betragen.

12. Fehlerortungssystem nach einem der Ansprüche 8 bis 11, wobei die ersten und die zweiten Ausgabeabtastungen eine Veränderung der Stromstärke oder eine Veränderung der Spannung angeben; und

wobei die Verarbeitungseinheit ferner dazu ausgelegt ist, eine erste Spitzenveränderung des Satzes der ersten Ausgabeabtastungen und eine zweite Spitzenveränderung des Satzes der zweiten Ausgabeabtastungen zu bestimmen;
wobei die Bestimmung der ersten Ankunftszeit auf einer Ankunftszeit der ersten Spitzenveränderung basiert und die Bestimmung der zweiten Ankunftszeit auf einer Ankunftszeit der zweiten Spitzenveränderung basiert.

13. Fehlerortungssystem nach einem der Ansprüche 8 bis 12,

wobei der erste Ort und der zweite Ort gleich sind oder sich an einer gleichen Position entlang der Übertragungsleitung befinden, wobei der mindestens eine Delta-Signal-Modulator einen einzelnen Delta-Sigma-Modulator umfasst, der sich an dem ersten und dem zweiten Ort befindet, und wobei die zweite Wanderwelle eine reflektierte Wanderwelle ist;
oder
wobei der erste Ort und der zweite Ort verschieden sind und/oder sich an entgegengesetzten Positionen entlang der Übertragungsleitung relativ zu dem Ort des Fehlers befinden und wobei der mindestens eine Delta-Signal-Modulator einen ersten Delta-Sigma-Modulator umfasst, der sich an dem ersten Ort befindet, und einen zweiten Delta-Sigma-Modulator, der sich an dem zweiten Ort befindet.

14. Fehlerortungssystem nach einem der Ansprüche 8 bis 13, mindestens einen Delta-Sigma-ADU (150) umfassend, der den mindestens einen Delta-Sigma-Modulator und den mindestens einen Filter umfasst.

## Revendications

1. Procédé (1000) de détermination d'un emplacement d'un défaut dans une ligne de transmission, le défaut entraînant la propagation d'une première onde progressive et d'une deuxième onde progressive depuis ledit emplacement dans des sens opposés le long de la ligne de transmission, le procédé comprenant :

la détermination (1001) d'un premier instant d'arrivée de la première onde progressive à un première emplacement et d'un deuxième instant d'arrivée de la deuxième onde progressive à un deuxième emplacement ;

la détermination (1002) de l'emplacement du défaut sur la base au moins d'une différence entre les premier et deuxième instants d'arrivée et d'une vitesse d'onde des première et deuxième ondes progressives le long de la ligne de transmission ;

le procédé comprenant en outre :

> un échantillonnage (1010) de signaux de la ligne de transmission, à un taux de modulation, en utilisant une modulation Delta-Sigma au premier emplacement de la ligne de transmission et au deuxième emplacement de la ligne de transmission ;
>
> le filtrage (1021) des signaux échantillonnés au premier emplacement, et la fourniture (1025), à un premier débit de sortie, de premiers échantillons de sortie sur la base des signaux filtrés échantillonnés au premier emplacement ;
>
> le filtrage (1022) des signaux échantillonnés au deuxième emplacement, et la fourniture (1026), à un deuxième débit de sortie, de deuxièmes échantillons de sortie sur la base des signaux filtrés échantillonnés au deuxième emplacement ;
>
> la détermination du premier instant d'arrivée étant basée sur un ensemble des premiers échantillons de sortie, et la détermination du deuxième instant d'arrivée étant basée sur un ensemble des deuxièmes échantillons de sortie ; et
>
> le taux de modulation étant supérieur aux premier et deuxième débits de sortie.

2. Procédé selon la revendication 1, les signaux échantillonnés au premier emplacement étant filtrés en utilisant un filtre de moyennage ou un filtre sinusoïdal, et les signaux échantillonnés au deuxième emplacement étant filtrés en utilisant un filtre de moyennage ou un filtre sinusoïdal.

3. Procédé selon la revendication 1 ou 2, les premier et deuxième échantillons de sortie indiquant un changement de courant ou un changement de tension ; et

> le procédé comprenant en outre la détermination (1030) d'un premier changement de crête de l'ensemble des premiers échantillons de sortie et d'un deuxième changement de crête de l'ensemble des deuxièmes échantillons de sortie ;
>
> la détermination (1001) du premier instant d'arrivée étant basée sur un instant d'arrivée du premier changement de crête, et la détermination du deuxième instant d'arrivée étant basée sur un instant d'arrivée du deuxième changement de crête.

4. Procédé selon l'une quelconque des revendications 1 à 3, le premier emplacement et le deuxième emplacement étant identiques, ou à une même position le long de la ligne de transmission, et la deuxième onde progressive étant une onde progressive réfléchie.

5. Procédé selon l'une quelconque des revendications 1 à 3, le premier emplacement et le deuxième emplacement étant différents et/ou situés à des positions opposées le long de la ligne de transmission par rapport à l'emplacement de défaut.

6. Procédé selon la revendication 5, la détermination d'un emplacement du défaut étant en outre basée sur une distance entre les premier et deuxième emplacements et/ou une position géographique d'au moins un des premier et deuxième emplacements.

7. Procédé selon l'une quelconque des revendications précédentes, le taux de modulation étant au moins 10 fois supérieur aux premier et deuxième débits de sortie, et/ou le taux de modulation étant supérieur à 10 MHz.

8. Système (100) de localisation de défaut pour déterminer un emplacement (101) d'un défaut (102) dans une ligne de transmission (103), le défaut entraînant la propagation d'une première onde progressive et d'une deuxième onde progressive dans des directions opposées le long de la ligne de transmission, le système de localisation de défauts comprenant :
une unité de traitement (110) configurée pour :

> déterminer un premier instant d'arrivée de la première onde progressive à un premier emplacement (104) et un deuxième instant d'arrivée de la deuxième onde progressive à un deuxième emplacement (105, 205) ;
>
> déterminer l'emplacement du défaut sur la base au moins d'une différence entre les premier et deuxième instants d'arrivée et d'une vitesse d'onde des première et deuxième ondes progressives le long de la ligne de transmission ;
>
> le système de localisation de défaut comprenant en outre :
>
> au moins un modulateur Delta-Sigma (120) connecté à la ligne de transmission à un premier emplacement et un deuxième emplacement, et configuré pour échantillonner des signaux de la ligne de transmission à un premier taux de modulation au premier emplacement de la ligne de transmission et configuré pour échantillonner des signaux de la ligne de transmission à un deuxième taux de modulation au deuxième emplacement de la ligne de transmission ; et

au moins un filtre (130) configuré pour filtrer les signaux échantillonnés au premier emplacement et les signaux échantillonnés au deuxième emplacement ;

ledit au moins un filtre étant configuré pour : fournir, à l'unité de traitement, des premiers échantillons de sortie, à un premier débit de sortie, sur la base des signaux filtrés échantillonnés au premier emplacement et des deuxièmes échantillons de sortie, à un deuxième débit de sortie, sur la base des signaux filtrés échantillonnés au deuxième emplacement ; et l'unité de traitement étant en outre configurée pour :

déterminer le premier instant d'arrivée sur la base d'un ensemble des premiers échantillons de sortie et le deuxième instant d'arrivée sur la base d'un ensemble des deuxièmes échantillons de sortie ; les premier et deuxième taux de modulation étant plus élevés que les premier et deuxième débits de sortie.

9. Système de localisation de défaut selon la revendication 8, l'au moins un filtre (130) comportant au moins un d'un filtre passe-bas, d'un filtre de moyennage et d'un filtre sinusoïdal.

10. Système de localisation de défaut selon la revendication 8 ou 9, la détermination de l'emplacement du défaut étant en outre basée sur une distance entre les premier et deuxième emplacements et/ou une position géographique d'au moins un des premier et deuxième emplacements.

11. Système de localisation de défauts selon l'une quelconque des revendications 8 à 10, les premier et deuxième taux de modulation étant au moins 10 fois supérieurs aux premier et deuxième débits de sortie, respectivement, et/ou les premier et deuxième taux de modulation étant supérieurs à 10 MHz.

12. Système de localisation de défaut selon l'une quelconque des revendications 8 à 11, les premier et deuxième échantillons de sortie indiquant un changement de courant ou un changement de tension ; et

l'unité de traitement étant en outre configurée pour déterminer un premier changement de crête de l'ensemble des premiers échantillons de sortie et un deuxième changement de crête de l'ensemble des deuxièmes échantillons de sortie ; la détermination du premier instant d'arrivée étant basée sur un instant d'arrivée du premier changement de crête, et la détermination du deuxième instant d'arrivée étant basée sur un instant d'arrivée du deuxième changement de crête.

13. Système de localisation de défaut selon l'une quelconque des revendications 8 à 12,

le premier emplacement et le deuxième emplacement étant le même, ou à une même position le long de la ligne de transmission, ledit au moins un modulateur Delta-Sigma comprenant un unique modulateur Delta-Sigma situé auxdits premier et deuxième emplacements, et la deuxième onde progressive étant une onde progressive réfléchie ; ou le premier emplacement et le deuxième emplacement étant différents et/ou situés à des positions opposées le long de la ligne de transmission par rapport à l'emplacement de défaut, et ledit au moins un modulateur Delta-Sigma comprenant un premier modulateur Delta-Sigma situé audit premier emplacement et un deuxième modulateur Delta-Sigma situé audit deuxième emplacement.

14. Système de localisation de défaut selon l'une quelconque des revendications 8 à 13, comprenant au moins un CAN Delta-Sigma (150) comprenant l'au moins un modulateur Delta-Sigma et l'au moins un filtre.

Fig. 1a

Fig. 1b

EP 4 558 837 B1

Fig. 2

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015081235 A
- EP 2546943 A
- US 2009315537 A
- US 9698809 B
- EP 3961836 A1

**Non-patent literature cited in the description**

- **O. D. NAIDU** ; **ASHOK KUMAR PRADHAN**. Precise Traveling Wave Based Transmission Line Fault Location Method Using Single-Ended Data. *IEEE Transaction on Industrial Informatics*, August 2021, vol. 17 (8)